# EUROPEAN PATENT APPLICATION

(11) **EP 4 852 168 A1**
(43) Date of publication of application: **09.12.2026**
(21) Application number: 24922035.1
(22) Date of filing: 16.12.2024
(51) Int. Cl.: H01M 50/204, H01M 50/213, H01M 50/271, H02J 7/00, H02J 7/02, H05K 5/02

(54) **POWER SUPPLY DEVICE**

(30) Priority: 29.01.2024 JP 2024011207
(71) Applicant: Panasonic Intellectual Property Management Co., Ltd., Kadoma-shi, Osaka 571-0057 (JP)
(72) Inventor: MIURA, Takumu, kadoma-shi, Osaka 571-0057 (JP)
(74) Representative: Eisenführ Speiser
(86) International application number: PCT/JP2024/044422
(87) International publication number: WO 2025/164117

(57) **Abstract**

A power supply device includes a housing accommodating a battery assembly therein. The housing includes a main body having a box shape having an open top, a front cover that covers a front of the main body, and a top cover that is connected to a top of the main body. The main body includes a bottom cover, an inner cover, and a rear cover. Each of the rear cover and the inner cover includes a lower end portion that is connected to the bottom cover via a first waterproof member, and overlapping portions of the lateral surfaces are connected via a second waterproof member. The inner cover includes an inner plate that closes an opening window provided in the upper end portion with a waterproof structure. While the front cover is connected to the main body, the flange of the front cover is flush with the flange of the rear cover, and the top cover is connected via a third waterproof member with a waterproof structure.

## Description

### TECHNICAL FIELD

The present invention relates to a power supply device that includes a housing accommodating a battery assembly including secondary battery cells.

### BACKGROUND ART

A power supply device including a housing accommodating a battery assembly of secondary battery cells therein is used for a power storage system for households, factories, and the like. In the power supply device, for example, the secondary battery cells are accommodated as the battery assembly in the housing. In a household power storage system and the like, the power supply device may be installed outdoors. Since the power storage system installed outdoors is exposed to wind and rain, the housing accommodating the battery assembly therein is required to have a waterproof structure. Power supply devices that include housings with a waterproof structure have been developed (see PTL 1 and PTL 2).

The power supply devices described above have a complicated configuration due to the waterproof structure of the housing. Additionally, there are issues such as the inability to easily disassemble the housing at the time of maintenance. Furthermore, there are restrictions on the screw fastening directions and locations, and there are issues such as the appearance being compromised due to the screws used to fix the exterior components. In particular, the power supply device requires safety components (fuses and circuit breakers) to be operated or replaced either regularly or in the event of a malfunction. Therefore, it is necessary to construct the housing with removable exterior components and to improve the efficiency of the work involved in removal. The waterproof performance can be easily achieved by filling the joints between the components with adhesive and the like. However, this configuration does not allow the components to be removed, making on-site work difficult.

### CITATION LIST

### Patent Literature

PTL 1: Japanese Patent No. 6989040
PTL 2: Japanese Patent No. 7276171

### SUMMARY OF INVENTION

A power supply device according to one aspect of the present disclosure includes: a battery assembly including a plurality of secondary battery cells; and a housing accommodating the battery assembly therein. The housing includes: a main body accommodating the battery assembly therein, the main body having a box shape having an opening in a top thereof; a front cover detachably connected to a front surface of the main body to cover the front surface of the main body; and a top cover detachably connected to a top surface of the main body to which the front cover has been connected. The main body includes: a bottom cover on which the battery assembly is placed, the bottom cover having a rectangular shape in plan view; an inner cover including a front panel, a pair of bent portions, and an inner plate, the front panel being positioned at a front side of the main body, the pair of bent portions being connected to both side edges of the front panel to constitute parts of a pair of lateral surfaces of the main body; and a rear cover including a rear panel, a pair of lateral panels, and a flange, the rear panel being positioned at a rear side of the main body, the pair of lateral panels being connected to both side edges of the rear panel to constitute the pair of lateral surfaces of the main body, the pair of lateral panels including front end portions that overlap the pair of bent portions of the inner cover and that are connected to the pair of bent portions of the inner cover, the flange being bent inward at upper edges of the rear panel and the pair of lateral panels. Each of the rear cover and the inner cover includes a lower end portion that is connected to the bottom cover via a first waterproof member with a waterproof structure, and portions of the pair of bent portions of the inner cover overlapping the pair of lateral panels are connected to the pair of lateral panels via a second waterproof member with a waterproof structure. The inner plate of the inner cover has an opening window provided in a central portion of an upper end portion of the front panel, and the inner plate is detachably connected to the opening window to close the opening window with a waterproof structure. The front cover includes: a front-side panel covering the front panel of the inner cover; a pair of bent cover portions connected to both side edges of the front-side panel to cover the pair of bent portions; and a flange bent inward at upper edges of the front-side panel and the pair of bent cover portions. While the front cover is connected to the main body, the flange of the front cover is flush with the flange of the rear cover. The top cover has a rectangular shape in plan view, and is connected to the flange of the front cover and the flange of the rear cover via a third waterproof member provided along an outer peripheral edge of the top cover with a waterproof structure.

The power supply device according to the one aspect of the present disclosure provides both an easily detachable structure and a waterproof structure while simplifying the configuration of the housing. As a result, maintenance work can be performed efficiently.

### BRIEF DESCRIPTION OF DRAWINGS

FIG. 1 is a perspective view of a power supply device according to Exemplary Embodiment 1.
FIG. 2 is a vertical longitudinal sectional view of the power supply device illustrated in FIG. 1.
FIG. 3 is a vertical transverse cross-sectional view of the power supply device illustrated in FIG. 1.
FIG. 4 is a horizontal cross-sectional view of the power supply device illustrated in FIG. 1.
FIG. 5 is an exploded perspective view of the power supply device illustrated in FIG. 1.
FIG. 6 is an exploded perspective view of a main body of a housing of the power supply device illustrated in FIG. 5.
FIG. 7 is an enlarged cross-sectional view of the power supply device according to Embodiment 1 for illustrating a connection structure between a bottom cover and an inner cover of the power supply device.
FIG. 8 is an exploded perspective view of the power supply device for illustrating the connection structure between the bottom cover and the inner cover illustrated in FIG. 7.
FIG. 9 is an enlarged partial exploded perspective view of the power supply device according to Embodiment 1 for illustrating a connection structure between the inner cover and a rear cover of the power supply device.
FIG. 10 is an enlarged cross-sectional view of the power supply device for illustrating the connection structure between the inner cover and the rear cover illustrated in FIG. 9.
FIG. 11 is an enlarged perspective view of the power supply device according to Embodiment 1 for illustrating a flange of the rear cover of the power supply device.
FIG. 12 is an enlarged partial perspective view of the power supply device according to Embodiment 1 for illustrating the bottom cover of the power supply device.
FIG. 13 is an enlarged partial perspective view of the power supply device according to Embodiment 1 for illustrating another example of the bottom cover of the power supply device.
FIG. 14 is an exploded perspective view of the power supply device according to Embodiment 1 for illustrating another example of an inner plate of the power supply device.
FIG. 15 is a rear perspective view of the inner plate illustrated in FIG. 14.
FIG. 16 is an enlarged cross-sectional view of the housing that includes the inner plate illustrated in FIG. 15.
FIG. 17 is an exploded perspective view of the power supply device according to Embodiment 1 for illustrating a connection structure between the main body and a front cover of the power supply device.
FIG. 18 is a perspective view of the power supply device for illustrating the connection structure between the main body and the front cover illustrated in FIG. 17.
FIG. 19 is an exploded cross-sectional view of the power supply device according to Embodiment 1 for illustrating a connection structure between the front cover, the main body, and a top cover of the power supply device.
FIG. 20 is a cross-sectional view of the power supply device for illustrating the connection structure between the front cover, the main body, and the top cover illustrated in FIG. 19.

### DESCRIPTION OF EMBODIMENT

A power supply device according to one aspect of the present disclosure includes: a battery assembly including a plurality of secondary battery cells; and a housing accommodating the battery assembly therein. The housing includes: a main body accommodating the battery assembly therein, the main body having a box shape having an opening in a top thereof; a front cover detachably connected to a front surface of the main body to cover the front surface of the main body; and a top cover detachably connected to a top surface of the main body to which the front cover has been connected. The main body includes: a bottom cover on which the battery assembly is placed, the bottom cover having a rectangular shape in plan view; an inner cover including a front panel, a pair of bent portions, and an inner plate, the front panel being positioned at a front side of the main body, the pair of bent portions being connected to both side edges of the front panel to constitute parts of a pair of lateral surfaces of the main body; and a rear cover including a rear panel, a pair of lateral panels, and a flange, the rear panel being positioned at a rear side of the main body, the pair of lateral panels being connected to both side edges of the rear panel to constitute the pair of lateral surfaces of the main body, the pair of lateral panels including front end portions that overlap the pair of bent portions of the inner cover and that are connected to the pair of bent portions of the inner cover, the flange being bent inward at upper edges of the rear panel and the pair of lateral panels. Each of the rear cover and the inner cover includes a lower end portion that is connected to the bottom cover via a first waterproof member with a waterproof structure, and portions of the pair of bent portions of the inner cover overlapping the pair of lateral panels are connected to the pair of lateral panels via a second waterproof member with a waterproof structure. The inner plate of the inner cover has an opening window provided in a central portion of an upper end portion of the front panel, and the inner plate is detachably connected to the opening window to close the opening window with a waterproof structure. The front cover includes: a front-side panel covering the front panel of the inner cover; a pair of bent cover portions connected to both side edges of the front-side panel to cover the pair of bent portions; and a flange bent inward at upper edges of the front-side panel and the pair of bent cover portions. While the front cover is connected to the main body, the flange of the front cover is flush with the flange of the rear cover. The top cover has a rectangular shape in plan view, and is connected to the flange of the front cover and the flange of the rear cover via a third waterproof member provided along an outer peripheral edge of the top cover with a waterproof structure.

With the above configuration, for the bottom cover, the inner cover, and the rear cover which are included in the main body having a box shape with an open top, the bottom surface and the lateral surfaces are reliably waterproofed via the first waterproof member and the second waterproof member. In addition, the inner plate, which is easily detachable, is connected to the opening window of the inner cover with a waterproof structure, allowing for both front-opening and waterproofing. Furthermore, the configuration in which the flanges of the front cover and the rear cover connected to the main body are covered with the top cover via the third waterproof member, achieves both top-opening and waterproofing. This allows for easy assembly of the housing while ensuring reliable waterproofing of the top and front sides of the housing. In particular, by dividing the functions of the front waterproofing and the top waterproofing between the inner plate and the front cover, both an easily detachable structure and waterproof structure can be achieved.

Moreover, with the above configuration, the top of the main body can be opened by removing the top cover of the housing in which the battery assembly is housed, and the front surface of the main body can be opened by removing the front cover and the inner plate and opening the opening window of the inner cover. With this, the top opening of the main body and the opening window continuous from the top opening toward the front can be opened up, and a large region free of obstructions to the battery assembly housed in the housing can be opened up, making work safe and efficient.

In a power supply device according to another aspect of the present disclosure, in the above aspect, each of the pair of bent portions of the inner cover includes an overlapping portion placed on a corresponding one of the pair of lateral panels of the rear cover, the overlapping portion being provided in a region of the each of the pair of bent portions excluding a lower end portion of the each of the pair of bent portions that faces the bottom cover. The second waterproof member is a gasket extending on the overlapping portion in an up-down direction.

With the above configuration, each bent portion of the inner cover includes an overlapping portion on which the lateral panel of the rear cover is placed, and a gasket is provided as the second waterproof member and extends on the overlapping portion in the up-down direction. Accordingly, the overlapping portions of the bent portions of the inner cover and the lateral panels of the rear cover are connected with a watertight structure from the upper to the lower sides, ensuring reliable waterproofing on the lateral sides of the main body.

In a power supply device according to another aspect of the present disclosure, in any one of the above aspects, the first waterproof member includes: an inner waterproof portion provided between the inner cover and the bottom cover; and a rear waterproof portion provided between the rear cover and the bottom cover. The rear waterproof portion is thicker than the inner waterproof portion to provide a stepped portion. Each of the pair of lateral panels of the rear cover overlaps and is connected to the rear waterproof portion that protrudes from the inner cover connected to the bottom cover and the second waterproof member provided on the overlapping portion of the inner cover while the each of the pair of lateral panels faces the second waterproof member via the inner waterproof portion, and each of the pair of bent portions of the inner cover and a corresponding one of the pair of lateral panels of the rear cover are arranged in a stepped structure. While the front cover is connected to the main body, a rear edge of one of the pair of bent cover portions faces a front edge of one of the pair of lateral panels, the one of the pair of bent cover portions being flush with the one of the pair of lateral panels, and a rear edge of another of the pair of bent cover portions faces a front edge of another of the pair of lateral panels, the another of the pair of bent cover portions being flush with the another of the pair of lateral panels.

In the above configuration, the first waterproof member provided on the bottom cover includes the rear waterproof portion and the inner waterproof portion having different thicknesses. This configuration allows the bend portion of the inner cover and the lateral panel of the rear cover to be arranged in a stepped structure, and allows the rear edge of the bent cover portion of the front cover and the front edge of the lateral panel to face each other, and allows the bent cover portion and the lateral panel to be flush with each other. As a result, a pleasing aesthetic appearance can be achieved with the lateral surfaces of the housing as a flush structure.

In a power supply device according to another aspect of the present disclosure, in any one of the above aspects, the bottom cover includes: a bottom plate to which the battery assembly is fixed; and a peripheral wall that extends along an outer peripheral edge of the bottom plate and that protrudes downward. The first waterproof member is a gasket provided on an outer surface of the peripheral wall and having a loop shape extending along the outer surface of the peripheral wall. The gasket is provided along an upper region of the outer surface of the peripheral wall, and a lower end portion of the inner cover is fixed to a lower end portion of the rear cover in a lower region of the outer surface of the peripheral wall.

With the above configuration, the bottom cover includes a peripheral wall that protrudes downward along the outer peripheral edge of the bottom plate, and the first waterproof member that is a gasket is provided in a loop along the upper region of the outer surface of the peripheral wall. Accordingly, the gasket can be provided along a large-area outer surface. As a result, the space between the inner cover and the rear cover and the bottom cover can be sealed securely in a watertight manner to provide a waterproof structure. Moreover, the gasket is provided in the upper region of the outer surface of the peripheral wall, and the lower end portion of the inner cover and the lower end portion of the rear cover are fixed in the lower region of the outer surface of the peripheral wall. Therefore, the waterproof function is not required for fixation in this portion, and manufacturing costs can be reduced by using simple fixing members.

In a power supply device according to another aspect of the present disclosure, in any one of the above aspects, the inner cover includes positioning portions that position the flange of the rear cover and the flange of the front cover in a region across which the flange of the rear cover faces the flange of the front cover, the positioning portions protruding inward from upper edges of the pair of bent portions. The positioning portions include: a pair of horizontal portions that are bent inward from the upper edges of the pair of bent portions; and a pair of upstand portions provided at top end portions of the pair of horizontal portions, the pair of upstand portions extending in a front-rear direction and protruding upward. An end portion of the flange of the rear cover facing an end portion of the flange of the front cover has one slit therein, and the end portion of the flange of the front cover has another slit therein, the one slit and the another slit guiding the pair of upstand portions. The one slit of the flange of the rear cover is guided toward rear ends of the pair of upstand portions to connect the rear cover to a fixed position on the inner cover. The another slit of the flange of the front cover is guided toward front ends of the pair of upstand portions to connect the front cover to a fixed position on the inner cover.

With the above configuration, the inner cover includes positioning portions which position the flange of the rear cover and the flange of the front cover and protrude inward from upper edges of the bent portions. Each of the flange of the rear cover and the flange of the front cover includes, at opposing end portions, slits that guide the upstand portions of the positioning member. Therefore, by guiding the slits of the flanges to the upstand portions, the rear cover and the front cover can be connected while positioning at fixed positions on the inner cover.

In a power supply device according to another aspect of the present disclosure, in any one of the above aspects, a width of each of the pair of horizontal portions of the positioning portions in the front-rear direction is 10 mm or more, and a protrusion height of each of the pair of upstand portions of the positioning portions is 1 mm or more, such that each of the positioning portions serves as a water-ingress prevention portion configured to prevent water from entering through a gap in a region across which the rear cover faces the front cover.

With the above configuration, in each positioning portion, the width of the horizontal portion in the front-rear direction is 10 mm or more, and the protrusion height of the upstand portion is 1 mm or more. Therefore, in the region where the flange of the rear cover and the flange of the front cover face each other, the positioning portion can also serve as a water-ingress prevention portion that prevents water, such as rainwater, from entering through a gap between the opposing portion between the rear cover and the front cover. This is because even when a small gap is generated at the abutting portion between the rear cover and the front cover and water enters through the gap, the horizontal portion having a predetermined width and the upstand portion having a predetermined height inhibit direct jet from entering through the gap, thereby preventing water from entering the main body.

In a power supply device according to another aspect of the present disclosure, in any one of the above aspects, the third waterproof member is a frame-shaped gasket that is fixed to an outer peripheral edge portion of a bottom surface of the top cover. Positioning members are fixed to corners of the flanges of the rear cover and the front cover positioned facing four corners of the top cover to position the frame-shaped gasket. Each of the positioning members has an L-shape in plan view along a corresponding one of the corners of the flanges of the rear cover and the front cover. Each of the positioning member includes: fixing portions provided at both ends of the each of the positioning members and fixed to a corresponding one of the flanges; an intermediate connection portion which is provided at an intermediate portion of the each of the positioning members, and to which the top cover is connected; and upstand portions provided between the intermediate portion and each of the fixing portions, the upstand portions positioning the intermediate portion at a predetermined height with respect to the fixing portions. While the four corners of the top cover are connected to the positioning members, the frame-shaped gasket is disposed at a fixed position along outer peripheral edges of the intermediate connection portions, and an elastic deformation amount of the frame-shaped gasket is determined by the predetermined height of the intermediate connection portions.

With the above configuration, positioning members that position the frame-shaped gasket fixed to the outer peripheral edge portion of the bottom surface of the top cover are fixed to the corners of the rear cover and the front cover. Each positioning member has a shape bent into an L-shape in plan view along the corner. The positioning member includes: fixing portions provided at both ends fixed to the flange; an intermediate connection portion connected to the top cover; and upstand portions which are provided between the intermediate portion and the fixing portions and arranges the intermediate portion at a predetermined height with respect to the fixing portions. Accordingly, while the frame-shaped gasket is arranged at a fixed position along outer peripheral edges of the intermediate connection portions, an elastic deformation amount of the frame-shaped gasket can be determined by a height of the intermediate connection portions. In particular, the intermediate connection portions of the positioning members fixed to the four corners of the top surfaces of the rear cover and the front cover are fitted so as to be positioned inside the corners of the frame-shaped gasket. Such a configuration allows the frame-shaped gasket to be arranged at predetermined positions on the flanges simply and reliably. Moreover, by the positioning members determining the elastic deformation amount of the frame-shaped gasket when the frame-shaped gasket is compressed, it is possible to inhibit the aging degradation of the frame-shaped gaskets while allowing the frame-shaped gasket to undergo proper elastic deformation over a long period of time, thereby achieving ideal waterproofing.

In a power supply device according to another aspect of the present disclosure, in any one of the above aspects, each of the pair of bent cover portions of the front cover is connected to the main body via a detachable connection member.

With the above configuration, the bent cover portions of the front cover that covers the front of the main body are connected to the main body via detachable connection members. Therefore, the aesthetically pleasing appearance can be achieved without exposing the detachable connection members on the front-side plate arranged on the front side of the housing.

In a power supply device according to another aspect of the present disclosure, in any one of the above aspects, the battery assembly includes a reinforcement frame that positions the plurality of secondary battery cells at fixed positions. The flanges of the rear cover and the front cover are disposed on a top surface of the reinforcement frame.

With the above configuration, since the flanges of the rear cover and the front cover are supported by the reinforcement frame of the battery assembly, a large load applied to the housing in the up-down direction can be supported by the reinforcement frame of the battery assembly. This can inhibit the deformation of the housing in response to the compressive force acting in the up-down direction.

In a power supply device according to another aspect of the present disclosure, in any one of the above aspects, the inner plate is fixed to the front panel while a fourth waterproof member is provided between an opening edge portion of the opening window of the front panel and the inner plate in an overlapping manner.

In a power supply device according to another aspect of the present disclosure, in any one of the above aspects, the inner plate includes: a main plate portion; a fourth waterproof member that covers an outer peripheral edge portion of the main plate portion; and inner plate portions that are provided on an inner side of the main plate portion to which the fourth waterproof member is attached to provide two grooves that guide an opening edge portion between the fourth waterproof member and each of the inner plate portions. The fourth waterproof member attached to the main plate portion is a frame-shaped gasket. At least on each of both sides of the main plate portion, one of the inner plate portions is disposed on an inner side of the frame-shaped gasket to provide a corresponding one of the two grooves. The inner plate portions are connected to the inner cover while the opening edge portion is guided along the two grooves.

With the above configuration, the inner plate is connected to the opening edge portion via the grooves provided on both sides of the inner plate. Therefore, the inner plate can be easily and simply attached and detached by sliding the opening edge portion along the grooves without using fixing members.

An exemplary embodiment of the present disclosure will be described below with reference to the drawings. Note that the following embodiment is an example for embodying the technical idea of the present disclosure, and is not intended to limit the present disclosure to the following description. Moreover, the present specification does not limit the members in the claims to members in the embodiment. In particular, dimensions, materials, shapes, and relative arrangement of structural components described in the embodiment are not intended to restrict the scope of the present disclosure thereto, but are mere explanatory examples, unless particularly specifically described. It is to be noted that sizes, positional relations and the like of members illustrated in each drawing may be exaggerated for clarifying a description Moreover, in the following description, the same name or symbol denotes the same member or members of the same quality, and a detailed description thereof will be omitted as appropriate. Moreover, each element included in the present disclosure may have a mode where a plurality of elements are made up of the same member and the one member may serve as the plurality of elements, or conversely, a function of one member can be shared and realized by a plurality of members.

A power supply device according to the present disclosure is a power supply device used for, for example, stationary power supply devices, e.g., for households, offices, and factories, such as power storage devices that store electric power obtained from photovoltaic power generation, and late night power, or power supplies for peak shaving during the day. In particular, the power supply device according to the present disclosure can be used as a power supply device installed outdoors and prevents ingress of rainwater and the like. Hereinafter, as one embodiment of the present disclosure, a power supply device will be described which is used as a household power storage device installed outdoors.

### Exemplary Embodiment 1

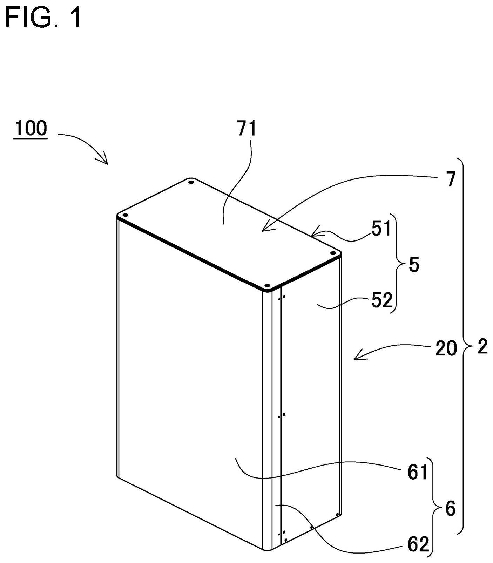

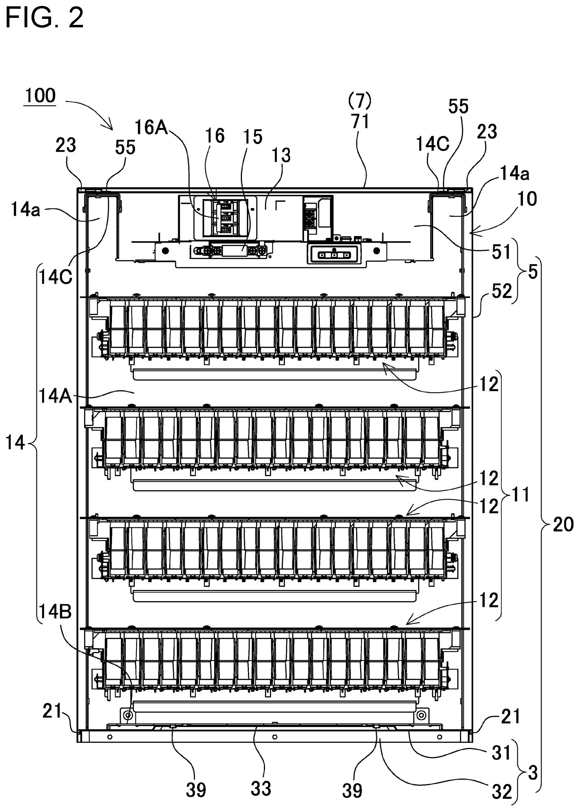

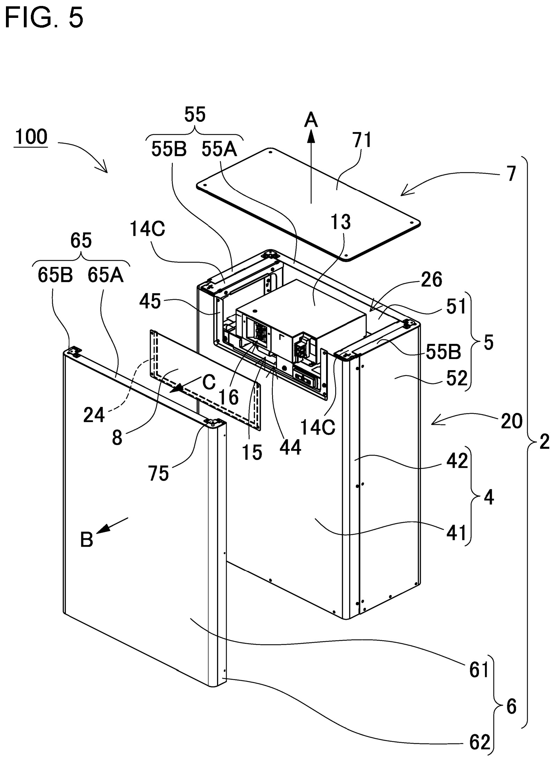

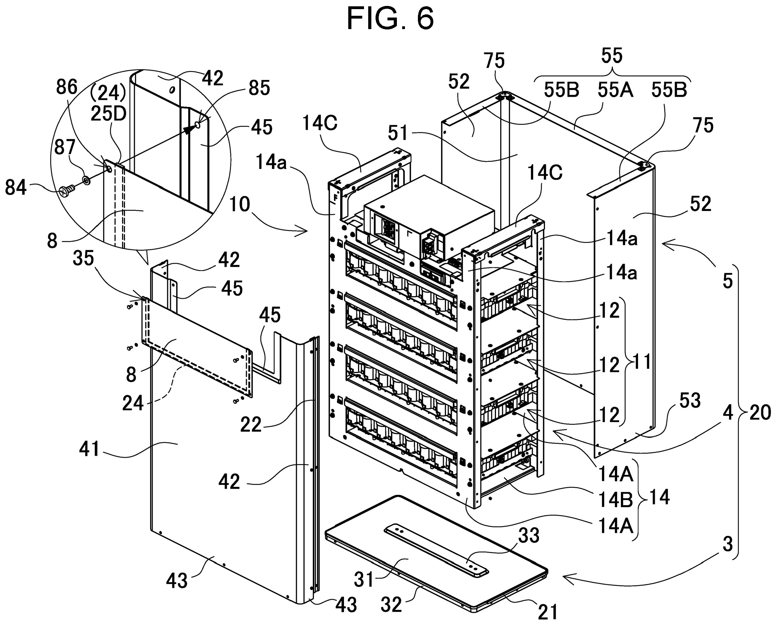

FIGS. 1 to 6 illustrate a power supply device according to Exemplary Embodiment 1 of the present disclosure. FIG. 1 is a perspective view of the power supply device. FIGS. 2 to 4 are a vertical longitudinal sectional view, a vertical transverse cross-sectional view, and a horizontal cross-sectional view of the power supply device illustrated in FIG. 1, respectively. FIG. 5 is an exploded perspective view of the power supply device illustrated in FIG. 1. FIG. 6 is an exploded perspective view of a main body of the power supply device illustrated in FIG. 5. Power supply device 100 illustrated in these figures includes battery assembly 10 that includes a plurality of secondary battery cells 1 and housing 2 accommodating battery assembly 10 therein.

### Battery Assembly 10

Battery assembly 10 illustrated in FIG. 2 to FIG. 6 includes battery assembly 11 that includes a plurality of secondary battery cells 1, electrical unit 13 accommodating therein electronic components configured to control or protect the charge and discharge of secondary battery cells 1 included in battery assembly 11, and reinforcement frame 14 that positions battery assembly 11 and electrical unit 13 at fixed positions.

### Secondary Battery Cell 1

Each secondary battery cell 1 is an energy-efficient non-aqueous electrolyte secondary battery, such as a lithium-ion secondary battery, can be suitably used. However, all rechargeable batteries, such as nickel-metal hydride batteries, nickel-cadmium batteries, or known secondary batteries such as solid-state batteries, can be appropriately used for the secondary battery cells. The secondary battery cell may include a cylindrical outer can, may be a prismatic cell, or may be a pouch cell.

### Battery Assembly 11, Battery Block 12

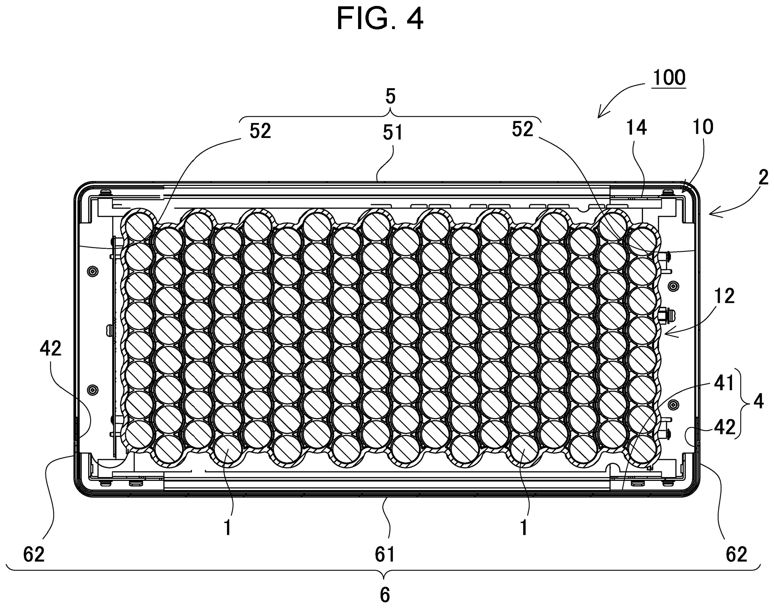

As illustrated in FIGS. 2 to 6, battery assembly 11 includes battery blocks 12 each of which includes a plurality of secondary battery cells 1. In battery assembly 10 illustrated in the figures, battery assembly 11 includes four battery blocks 12 arranged and spaced apart in the up-down direction. In each battery block 12 included in battery assembly 11, as illustrated in FIG. 4, a plurality of secondary battery cells 1 are arranged in the up-down direction parallel to each other, and are connected in series or in parallel to one another via lead plates. In this example, 144 secondary battery cells 1 are connected in 8-parallel and 18-series. The number of secondary battery cells 1 included in battery block 12, as well as the number of secondary battery cells 1 connected in series and in parallel, are not limited to this example, and are designed appropriately according to, for example, the specifications required for the power supply device. The number of battery blocks 12 that are stacked is also designed according to the specifications similarly.

### Reinforcement Frame 14

Reinforcement frame 14 includes a plurality of metal frames combined with one another to have an overall shape that is a rectangular parallelepiped tower shape. Reinforcement frame 14 in the figures includes: a pair of plate-shaped frames 14A that face each other in the front-rear direction, bottom frame 14B that connects the lower ends of opposing plate-shaped frames 14A in the front-rear direction to each other, and top frame 14C that connects the upper ends of facing plate-shaped frames 14A in the front-rear direction to each other. Each plate-shaped frame 14A has openings in the regions where battery blocks 12 are arranged, and includes, at the upper ends of both left and right ends, protrusions 14a that protrude upward. The upper ends of protrusions 14a that face each other in the front-rear direction are connected with top frames 14C. In reinforcement frame 14, the top and bottom of opposing plate-shaped frames 14A are connected with bottom frame 14B and top frames 14C, forming a three-dimensional shape. Reinforcement frame 14 includes a battery housing region where battery assembly 11 is accommodated, and an electrical unit housing region where electrical unit 13 is disposed. The upper region of reinforcement frame 14 in the figures between protrusions 14a provided on the left and right sides serves as the electrical unit housing region where electrical unit 13 is disposed. The lower region of reinforcement frame 14 sandwiched between the main body portions of facing plate-shaped frame 14A serves as the battery housing region where four battery blocks 12 are disposed.

### Housing 2

As illustrated in FIGS. 1 to 6, housing 2 has an overall shape of a rectangular box shape, and the inside of housing 2 is a hollow housing space. As illustrated in FIGS. 2 to 6, in the housing space, a plurality of battery blocks 12 are arranged in multiple tiers by reinforcement frame 14, and battery assembly 10 with electrical unit 13 arranged in the top portion is housed. As illustrated in FIG. 5, housing 2 includes: main body 20 which has a box shape having a top opening and accommodating battery assembly 10 therein; front cover 6 that is detachably connected to the front surface of main body 20 to cover the front surface of main body 20; and top cover 7 that is detachably connected to the top surface of main body 20 to which front cover 6 has been connected. The members included in housing 2 may be made of metal. However, the housing may be made of resin material, such as polycarbonate or ABS.

### Main Body 20

As illustrated in FIG. 6, box-shaped main body 20 includes: bottom cover 3 that forms the bottom surface of main body 20 and has a rectangular shape in plan view; inner cover 4 that forms the front side of main body 20; and rear cover 5 that forms the rear surface and both lateral surfaces of main body 20. Bottom cover 3, inner cover 4, and rear cover 5 are connected to form box-shaped main body 20 with a top opening. Each connected portion is connected via a waterproof member, providing a waterproof structure. Main body 20 in the figure constitutes the waterproof structure of the bottom surface by connecting bottom cover 3 and inner cover 4 and bottom cover 3 and rear cover 5 via first waterproof member 21. In addition, inner cover 4 and rear cover 5 connected to each other via second waterproof members 22 provide the waterproof structure of the lateral surfaces.

### Bottom Cover 3

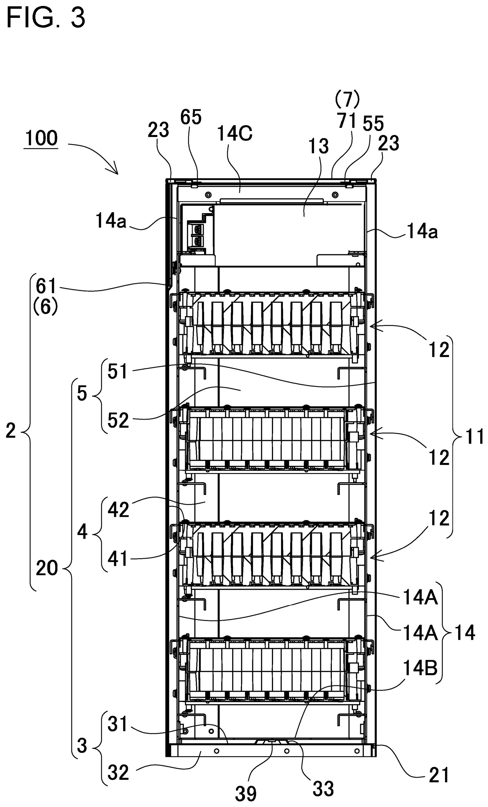

As illustrated in FIGS. 2 and 3, bottom cover 3 includes bottom plate 31 on which battery assembly 10 is placed and fixed, and peripheral wall 32 that protrudes downward from the outer peripheral edge of bottom plate 31. Metal bottom cover 3 may have a predetermined shape by press-forming a metal plate. Bottom cover 3 illustrated in FIG. 6 includes, in the central region of bottom plate 31, elongated rectangular raised portion 33 that is higher than a region surrounding raised portion 33. Fixing screws 39 that passes through raised portion 33 are fixed to bottom frame 14B of reinforcement frame 14, so that battery assembly 10 is fixed to bottom cover 3.

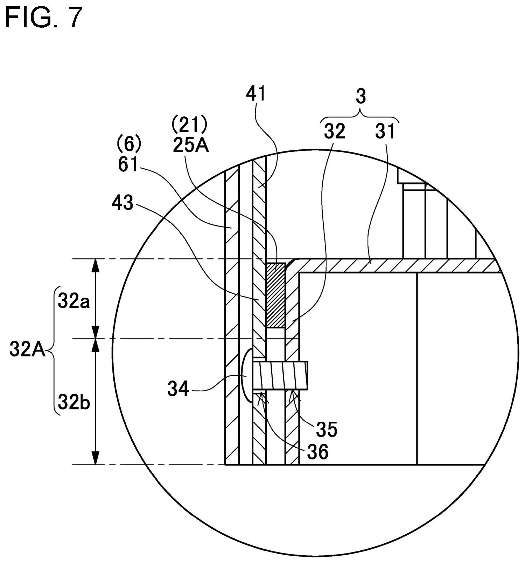

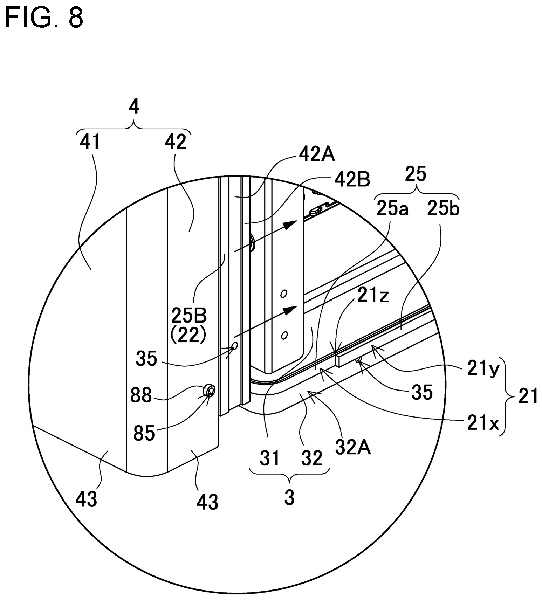

As illustrated in FIGS. 2 and 3, peripheral wall 32 has a tubular shape with a predetermined height, and includes outer surface 32A that has a predetermined vertical width. As illustrated in FIGS. 6 to 8, first waterproof member 21 is fixed along outer surface 32A of peripheral wall 32. First waterproof member 21 includes strip-shaped gasket 25A provided on outer surface 32A of peripheral wall 32 and having a loop shape extending along outer surface 32A of peripheral wall 32. Outer surface 32A of peripheral wall 32 has a vertical width sufficient to fix strip-shaped gasket 25A. This configuration allows gasket 25A to be closely adhered in the large area of lower end portions 43 and 53 of inner cover 4 and rear cover 5, ensuring reliable waterproofing. As illustrated in FIGS. 7 and 8, upper region 32a of outer surface 32A of peripheral wall 32 of bottom cover 3 serves as a region for fixing first waterproof member 21 that is strip-shaped gasket 25A, while lower region 32b of outer surface 32A of bottom cover 3 serves as a region for screwing lower end portions 43 and 53 of inner cover 4 and rear cover 5. In this configuration, strip-shaped gasket 25A is disposed in upper region 32a of outer surface 32A of peripheral wall 32, and lower end portions 43 and 53 of inner cover 4 and rear cover 5 are fixed to lower region 32b of outer surface 32A of peripheral wall 32. Therefore, the fixation can be achieved by using simple fixing members, such as simple set screws, without using fixing members with waterproof mechanisms. Furthermore, this portion does not need to be detachably connected, so that the fixation can also be achieved by using fixing members such as rivets. Bottom cover 3 illustrated in the figures fixes inner cover 4 and rear cover 5 with screw 34. Lower region 32b of peripheral wall 32 of bottom cover 3 has threaded holes 35 therein for screws 34.

### Inner Cover 4

As illustrated in FIG. 6, inner cover 4 includes front panel 41 positioned on the front of main body 20 and a pair of bent portions 42 that are connected to both side edges of front panel 41 to form part of the lateral surfaces of main body 20. As illustrated in FIGS. 7 and 8, lower end portions 43 of front panel 41 and bent portions 42 of inner cover 4 are connected to bottom cover 3 with a waterproof structure. Lower end portion 43 of inner cover 4 is fixed to peripheral wall 32 of bottom cover 3 with screws 34 that are inserted into insertion holes 36. Gasket 25 which is first waterproof member 21 is compressed by lower end portion 43 and peripheral wall 32 to provide a watertight connection.

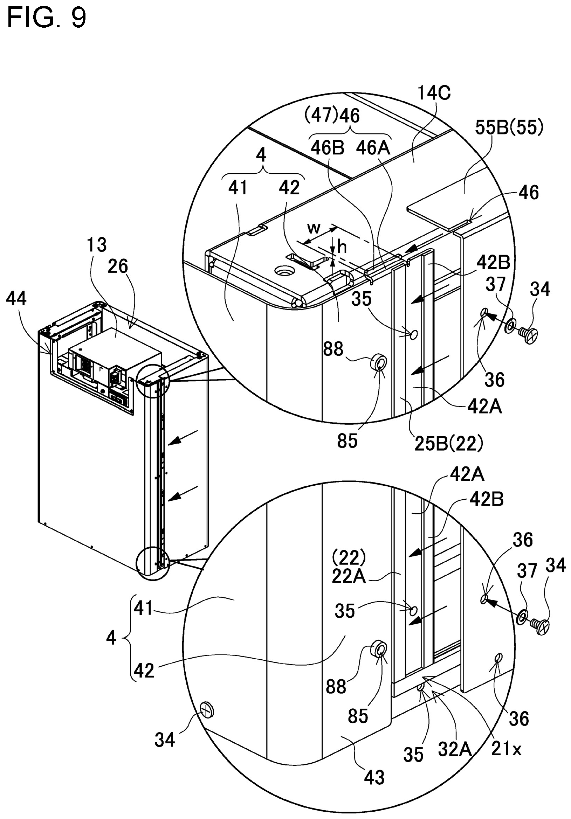

Bent portions 42 of inner cover 4 are connected to rear cover 5 with a waterproof structure. Each bent portion 42 of inner cover 4 illustrated in FIGS. 8 and 9 includes overlapping portion 42A that extends rearward in the region excluding lower end portion 43 that faces bottom cover 3. Lateral panel 52 of rear cover 5 overlaps and is fixed to overlapping portion 42A. As illustrated in FIG. 9, strip-shaped gasket 25B serving as second waterproof member 22 and extending in the up-down direction is provided in the front region of overlapping portion 42A of bent portion 42,. Bent portion 42 illustrated in the figure includes folded portion 42B in which the rear edge portion of overlapping portion 42A is folded in a U-shape to overlapping the rear edge portion on the outer surface. Folded portion 42B is configured to determine the maximum compression of gasket 25 while lateral panel 52 of rear cover 5 is fixed to overlapping portion 42A to sandwich gasket 25B.

As illustrated in FIGS. 6 and 8, inner cover 4 has opening window 44 provided in the central portion of the upper end portion of front panel 41. Front panel 41 illustrated in the figures has opening window 44 having a rectangular shape extending laterally from the central portion of the upper end portion. As illustrated in FIG. 5, inner cover 4 includes inner plate 8 that is detachably connected to opening window 44 to close opening window 44 with a waterproof structure. Opening edge portion 45 of opening window 44 of inner cover 4 illustrated in FIGS. 5 and 6 is recessed with respect to front panel 41. Inner plate 8 attached to opening edge portion 45 of opening window 44 is arranged to be flush with front panel 41. This configuration allows front cover 6 to be arranged on the front surface of inner cover 4 without a gap. Metal inner cover 4 has a predetermined shape by press-forming and bending a metal plate.

### Rear Cover 5

As illustrated in FIG. 6, rear cover 5 includes rear panel 51 positioned on the rear of main body 20, and a pair of lateral panels 52 which are connected to both side edges of rear panel 51 to form the lateral surfaces of main body 20, and have front end portions that overlap and connected to bent portions 42 of inner cover 4. Lower end portions 53 of rear panel 51 and lateral panels 52 of rear cover 5 are connected to bottom cover 3 with a waterproof structure. Similarly to inner cover 4, lower end portion 53 of rear cover 5 is fixed to peripheral wall 32 of bottom cover 3 with screws 34 inserted into insertion holes 36. Gasket 25 which is first waterproof member 21 is compressed by lower end portion 53 and peripheral wall 32 to provide a watertight connection.

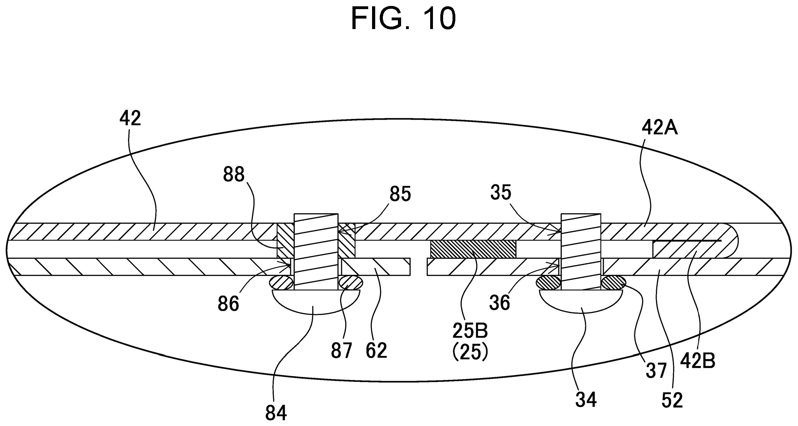

The front end portion of lateral panel 52 of rear cover 5 is placed on bent portion 42 of inner cover 4. In the overlapping portion, gasket 25B which is second waterproof member 22 is compressed by overlapping portion 42A of bent portion 42 and the front end portion of lateral panel 52 to provide a watertight connection. As illustrated in FIG. 10, lateral panel 52 of rear cover 5 which is placed on overlapping portion 42A of bent portion 42 is fixed in the region between gasket 25B fixed in the up-down direction on overlapping portion 42A and folded portion 42B via fixing members that have a waterproof function. For such fixing members, for example, screws 34 fixed via O-rings 37 or rivets can be used. As illustrated in the figure, lateral panel 52 through which screw 34 is inserted via O-ring 37 has insertion hole 36, and bent portion 42 into which screw 34 is inserted includes threaded hole 35 at a position facing insertion hole 36. As described above, the screws used for fixing inner cover 4 and rear cover 5 is not removed during use, and thus, tapping screws can also be used.

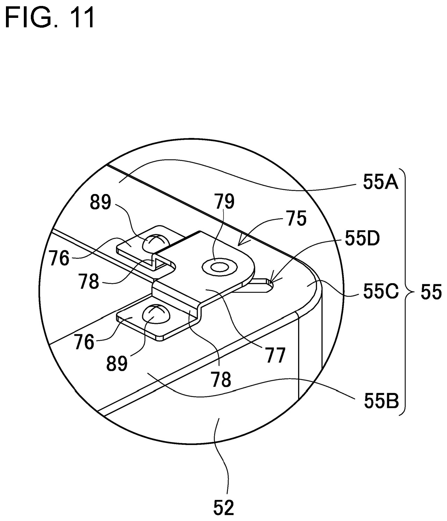

Rear cover 5 include flange 55 bent inward at the upper edges of rear panel 51 and lateral panels 52. Flange 55 illustrated in FIGS. 6 and 11 includes rear flange 55A provided at the upper end of rear panel 51, lateral flanges 55B provided at the upper ends of lateral panels 52, and connection flanges 55C provided at the upper ends of the boundaries between rear panel 51 and lateral panels 52. These flanges are connected so as to be flush with one another. In the boundary region which is between rear flange 55A and lateral flange 55B and excludes connection flange 55C, cutout 55D is provided to separate rear flange 55A from lateral flange 55B. Metal rear cover 5 has a predetermined shape by pressing-forming a metal plate.

### Positioning Portion 46

In order to determine the connection position of rear cover 5 which is placed on and fixed to inner cover 4, inner cover 4 illustrated in FIG. 9 includes positioning portion 46 that protrudes inward from the upper edge of bent portion 42 to position the connection position of flange 55 of rear cover 5. Positioning portion 46 illustrated in the figure includes horizontal portion 46A that is bent inward from the upper edge of bent portion 42, and upstand portion 46B that extends in the front-rear direction at the top end of horizontal portion 46A and protrudes upward. Flange 55 of rear cover 5 has slit 56 that guides upstand portion 46B toward the front end portion of lateral flange 55B that faces upstand portion 46B. Positioning portion 46 is connected to rear cover 5 while rear cover 5 is disposed at the fixed position on inner cover 4 by guiding slit 56 of flange 55 of rear cover 5 toward the rear end of upstand portion 46B that extends in the front-rear direction. Positioning portion 46, which will be detailed later, also functions as positioning portion 46 for determining the connection position of front cover 6 that is connected to the front surface of main body 20.

### First Waterproof Member 21

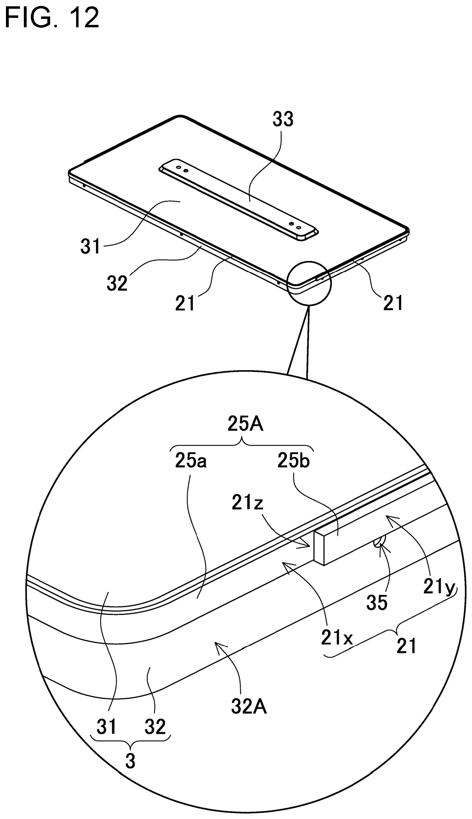

First waterproof member 21 is fixed to outer surface 32A of bottom cover 3 and has a loop shape extending along outer surface 32A of bottom cover 3. First waterproof member 21 is closely adhered to the inner surface of lower end portion 43 of inner cover 4, as well as to the inner surface of lower end portion 53 of rear cover 5, thereby providing a waterproof structure. First waterproof member 21 illustrated in FIGS. 8 and 12 includes inner waterproof portion 21x that is positioned between inner cover 4 and bottom cover 3, and rear waterproof portion 21y that is positioned between rear cover 5 and bottom cover 3. In first waterproof member 21, rear waterproof portion 21y is thicker than inner waterproof portion 21x to provide stepped portion 21z. A protruding amount of stepped portion 21z is larger than the thickness of bent portion 42. As illustrated in FIG. 9, rear waterproof portion 21y protrudes from inner cover 4 connected to bottom cover 3 via inner waterproof portion 21x. In this configuration, with lower end portion 43 of bent portion 42 arranged on inner waterproof portion 21x, the lower end of second waterproof member 22 fixed to overlapping portion 42A securely contacts rear waterproof portion 21y, thereby providing a waterproof structure in this connection portion. Lateral panel 52 of rear cover 5 is thus placed on and connected to rear waterproof portion 21y protruding from bent portion 42 and second waterproof member 22 provided on bent portion 42. As a result, lateral panel 52 of rear cover 5 is positioned higher than bent portion 42 of inner cover 4.

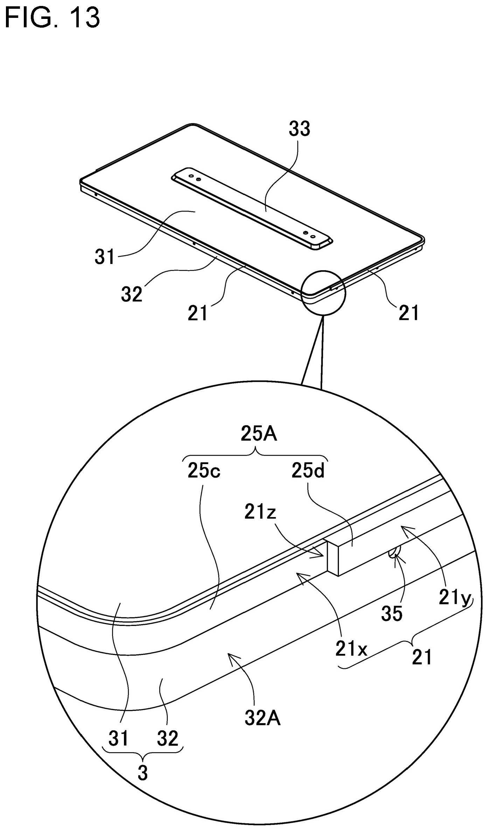

First waterproof member 21 illustrated in FIG. 12 includes two gaskets 25A to provide stepped portion 21z. First waterproof member 21 illustrated in the figure includes: first gasket 25a fixed in a loop along the entire periphery of outer surface 32A of bottom cover 3; and, in the region where lower end portion 53 of rear cover 5 is arranged, second gasket 25b layered and fixed over first gasket 25a. As a result, rear waterproof portion 21y is made thicker than inner waterproof portion 21x, providing stepped portion 21z. However, as illustrated in FIG. 13, first waterproof member 21 may also include two gaskets 25A having different thicknesses to provide stepped portion 21z. First waterproof member 21 illustrated in FIG. 13 includes inner waterproof portion 21x that is thinner third gasket 25c fixed in the region where lower end portion 43 of inner cover 4 is disposed, and rear waterproof portion 21y that is thicker fourth gasket 25d fixed in the region where lower end portion 53 of rear cover 5 is disposed. As a result, rear waterproof portion 21y is thicker than inner waterproof portion 21x, providing stepped portion 21z.

### Second Waterproof Member 22

Second waterproof member 22 is fixed to overlapping portion 42A of bent portion 42 of inner cover 4, and extends in the up-down direction, and securely contacts the inner surface of lateral panel 52 of rear cover 5, providing a waterproof structure between overlapping portion 42A of bent portion 42 and lateral panel 52. Second waterproof member 22 illustrated in FIG. 9 is strip-shaped gasket 25B extending from the upper end to the lower end of overlapping portion 42A. Gasket 25B securely contacts the opposing overlapping portion and lateral panel over a wide area for ensuring reliable waterproofing. Furthermore, the lower end of gasket 25B which extends in the up-down direction is close to or contacts first waterproof member 21, and the upper end of gasket 25B faces positioning portion 46 provided at the upper edge of bent portion 42, thereby providing the lateral panel with a reliable waterproof structure.

### Inner Plate 8

As illustrated in FIG. 6, inner plate 8 is detachably connected to opening edge portion 45 of opening window 44 of inner cover 4 to open and close opening window 44. Inner plate 8 illustrated in the figure is a rectangular plate that extends along opening window 44. The outer peripheral edge portion of inner plate 8 is connected to inner cover 4 with a waterproof structure while the outer peripheral edge portion of inner plate 8 overlaps and is placed on opening edge portion 45. Inner plate 8 illustrated in the figure includes fourth waterproof member 24 that is provided between inner plate 8 and opening edge portion 45 of opening window 44 and overlaps inner plate 8 and opening edge portion 45, thereby providing a waterproof structure. Fourth waterproof member 24 is strip-shaped gasket 25D that is arranged along opening edge portion 45. Opening edge portion 45 illustrated in the figure has a U-shape with an open top. Therefore, gasket 25D also has a U-shape in front view along opening edge portion 45, and is fixed to the outer peripheral edge portion of inner plate 8. Inner plate 8 is fixed to opening edge portion 45 via detachable connection members having a waterproof function in the region closer to the outer peripheral edge than gasket 25D is. For such detachable connection members, connection screws 84, which are fixed via O-rings 87, can be used. As illustrated in FIG. 6, inner plate 8, through which connection screws 84 are inserted via O-rings 87, has insertion holes 86. Opening edge portion 45 of front panel 41 into which connection screws 84 are inserted has threaded holes 85 at the positions opposing insertion holes 86.

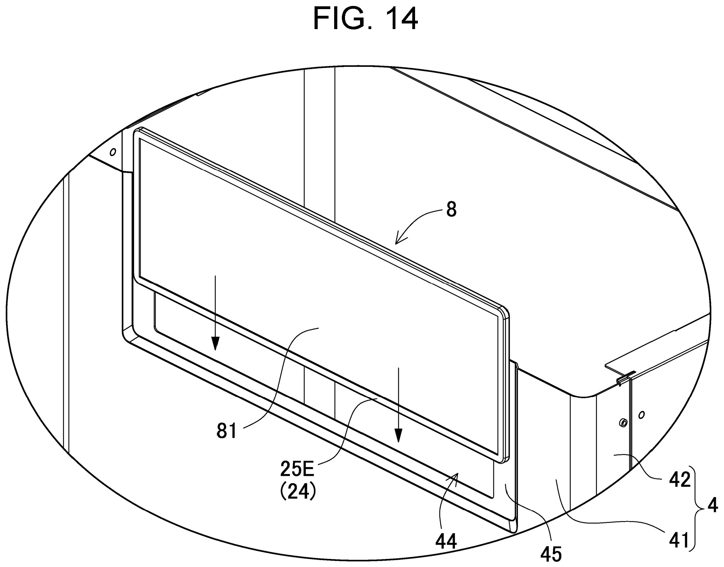

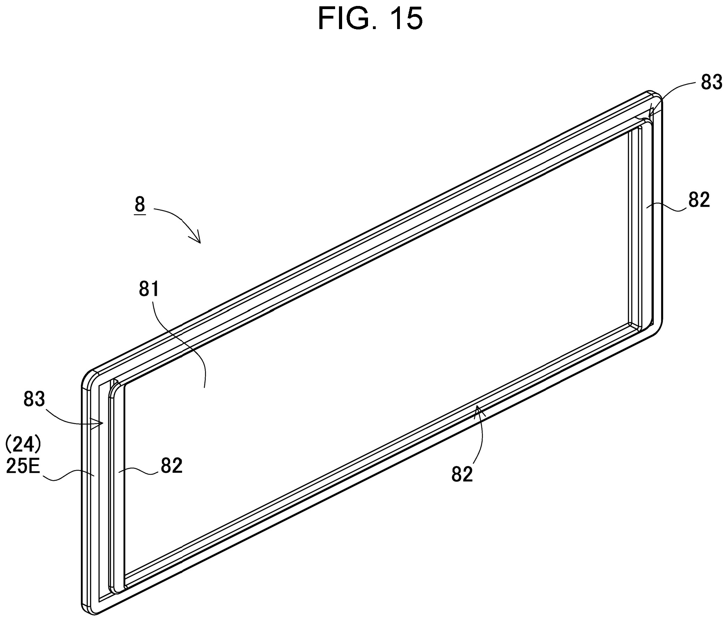

Inner plate 8 described above is connected to inner cover 4 with a simple configuration in a waterproofing manner. However, as illustrated in FIGS. 14 to 16, inner plate 8 may be detachably connected to opening edge portion 45 by sliding inner plate 8 up and down. Inner plate 8 illustrated in FIGS. 14 to 16 includes: rectangular main plate portion 81; fourth waterproof member 24 that covers the outer peripheral edge portion of main plate portion 81; and inner plate portions 82 which are provided on the inner side of main plate portion 81 with fourth waterproof member 24 attached to provide two grooves 83 that guide opening edge portion 45 between inner plate portion 82 and fourth waterproof member 24. Fourth waterproof member 24 attached to main plate portion 81 is frame-shaped gasket 25E, and includes, on the inner surface, inner groove 25m that guides the outer peripheral edge portion of main plate portion 81. Inner plate 8 includes, at least on each of both sides of main plate portion 81, inner plate portion 82 on the inner side of frame-shaped gasket 25E, and includes a corresponding one of two grooves 83. Opening edge portion 45 of front panel 41 is guided along two grooves 83 on the left and right sides and slid up and down to be attached to inner cover 4. Grooves 83 of inner cover 4 have widths determined such that gasket 25E fits tightly against opening edge portion 45 to maintain a watertight seal with opening edge portion 45 being guided along grooves 83, in other words, such that opening edge portion 45 is press-fitted.

Inner plate 8 illustrated in FIGS. 14 to 16 includes inner plate portions 82 that are formed unitarily with main plate portion 81. However, inner plate portions 82 may be provided as members separate from main plate portion 81. Inner plate 8 illustrated in the figures includes inner plate portions 82 only on the left and right sides, providing two grooves 83. However, inner plate 8 may include inner plate portion 82 at the lower end portion, too, providing another groove. Inner plate 8 guides the opening edge portion along the grooves provided in three directions to provide waterproofing. In addition, inner plate 8 may include the inner plate portions at the upper and lower end portions to provide grooves on the four sides. Such an inner plate can be attached to the opening edge portion regardless of the vertical orientation.

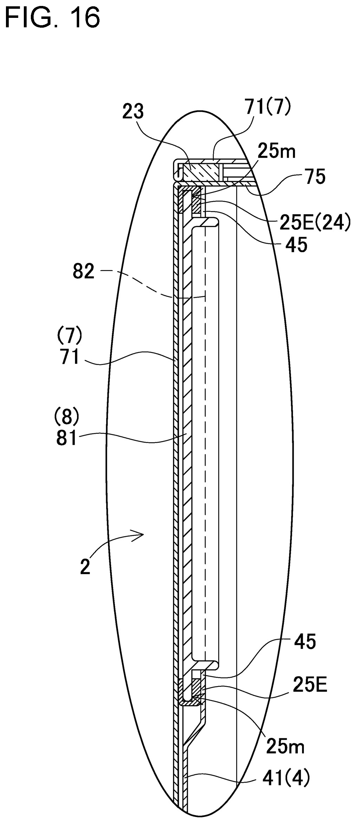

As for the configuration in which opening window 44 of front panel 41 of inner cover 4 is waterproof with inner plate 8, as illustrated in FIG. 16, rainwater may enter from outside due to the configuration in which this portion is covered with front cover 6. Hence, the waterproof structure in this portion can therefore be provided in a simple manner. Therefore, inner plate 8 may be easily detachable while providing a simple waterproof structure that reliably prevents the ingress of water.

### Front Cover 6

As illustrated in FIG. 5, front cover 6 is detachably connected to the front surface of main body 20 to cover inner cover 4. Front cover 6 has a shape that covers the front surface and lateral surfaces of inner cover 4. Front cover 6 includes front-side panel 61 that covers front panel 41 of inner cover 4, and bent cover portions 62 connected to both side edges of front-side panel 61 to cover bent portions 42 of inner cover 4. As illustrated in FIGS. 5, 17, and 18, while front cover 6 is connected to main body 20, the rear edge of bent cover portion 62 that covers bent portion 42 of inner cover 4 is disposed to face the front edge of lateral panel 52, so that bent cover portion 62 and lateral panel 52 are flush with each other. Therefore, as illustrated in FIG. 1, housing 2 can achieve a pleasing aesthetic appearance with no connection members such as screws on the front and with the flush lateral surfaces.

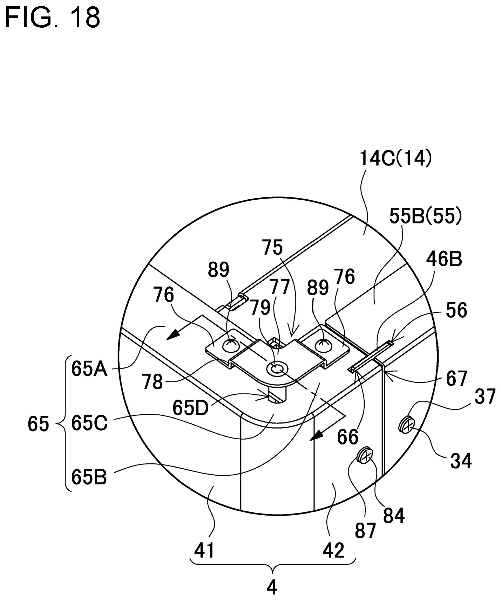

Bent cover portions 62 of front cover 6 that covers the front surface of main body 20 are fixed to bent portions 42 via detachable connection members having a waterproof function. For such detachable connection members, connection screws 84 which are fixed via O-rings 87, can be used. As illustrated in FIGS. 10 and 18, bent cover portion 62 through which connection screws 84 are inserted via O-rings 87 has insertion holes 86. Bent portion 42 into which connection screws 84 are inserted has threaded holes 85 in the positions facing insertion holes 86. Threaded holes 85 illustrated in the figures are nut members 88 inserted into bent portion 42. The configuration in which nut members 88 are provided as described above allows for reliable attachment and detachment of connection screws 84 over a long period of time. However, threaded holes 85 can be provided by processes such as burring, instead of using the nut members.

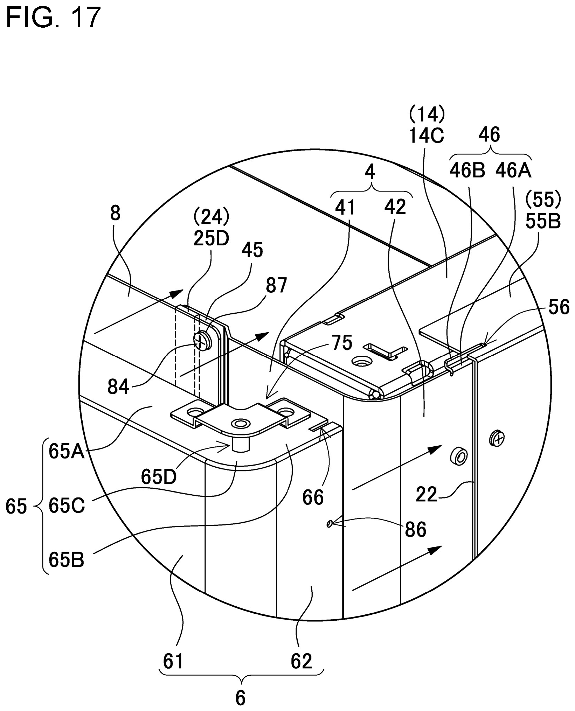

Front cover 6 includes flange 65 that is folded inward at the upper edges of front-side panel 61 and bent cover portion 62. Flange 65 illustrated in FIGS. 17 and 18 includes front flange 65A provided at the upper end of front-side panel 61, lateral flange 65B provided at the upper end of each bent cover portion 62, and connection flange 65C provided at the upper end of the boundary between front-side panel 61 and bent cover portion 62. Front flange 65A, lateral flange 65B, and connection flange 65C are connected to one another to be flush with one another. In the boundary region which is between front flange 65A and lateral flange 65B and excludes connection flange 65C, cutout 65D is provided to separate rear flange 65A and lateral flange 65B. Metal front cover 6 having the above configuration has a predetermined shape by press-forming a metal plate.

### Positioning Portion 46

In order to determine the connection positions of front cover 6 which is connected to cover inner cover 4, as illustrated in FIGS. 17 and 18, positioning portion 46 of inner cover 4 described above serves as positioning portion 46 for front cover 6. Flange 65 of front cover 6 has slit 66 therein that guides upstand portion 46B toward the rear end of lateral flange 65B that faces upstand portion 46B. Positioning portion 46 is connected to front cover 6 while front cover 6 is disposed at the fixed position on inner cover 4 by guiding slit 66 of flange 65 of front cover 6 toward the front end of upstand portion 46B that extends in the front-rear direction.

### Water-Ingress Prevention Portion 47

As illustrated in FIG. 18, positioning portion 46 also serves as water-ingress prevention portion 47 that prevents water from entering through gap 67 in a region across which rear cover 5 faces front cover 6. In the region where the upper end of lateral panel 52 of rear cover 5 faces the upper end of bent cover portion 62 of front cover 6, when gap 67 is generated at the abutting portion between rear cover 5 and front cover 6, water may enter through gap 67. In particular, water entering through gap 67 between the upper end of lateral panel 52 and the upper end of bent cover portion 62 may go over the upper end of inner cover 4, and enter main body 20, causing adverse effects. However, housing 2 illustrated in FIGS. 9 and 17 includes positioning portion 46 at the abutting portion between the upper end of rear cover 5 and the upper end of front cover 6. Positioning portion 46 includes horizontal portion 46A that protrudes inward and upstand portion 46B provided at the top end portion. Positioning portion 46 prevents the flow of direct jet entering through gap 67, preventing water from entering main body 20.

As illustrated in FIG. 9, in order to prevent the direct jet from entering, in positioning portion 46, the width (w) of horizontal portion 46A in the front-rear direction is 10 mm or more, and the protrusion height (h) of upstand portion 46B is 1 mm or more. Even when water enters through gap 67 at the abutting portion, with horizontal portion 46A having a predetermined width and upstand portion 46B having a predetermined height, positioning portion 46 configured as above serves as water-ingress prevention portion 47 configured to prevent the direct jet from entering through gap 67 and prevent the water from entering.

In housing 2 described above, flange 55 of rear cover 5 and flange 65 of front cover 6 are disposed on reinforcement frame 14 of battery assembly 10 accommodated in main body 20. Reinforcement frame 14 illustrated in the figures includes top frames 14C fixed on the left and right upper ends. On the top surfaces of top frames 14C, flange 55 of rear cover 5 and flange 65 of front cover 6 are disposed. This configuration allows reinforcement frame 14 of battery assembly 10 to prevent housing 2 from deforming even when a force acts in the compression direction due to a load from above.

### Top Cover 7

Top cover 7 is detachably connected to the top surface of main body 20 to which front cover 6 is connected. Top cover 7 is connected with a waterproof structure to the top surfaces of front cover 6 and rear cover 5 via third waterproof member 23 extending along the outer peripheral edge of top cover 7. Third waterproof member 23 is gasket 25C that has a frame shape along the outer peripheral edge of top cover 7 with a rectangular shape in plan view. Top cover 7 illustrated in FIGS. 5, 19, and 20 includes: top plate 71 with a rectangular shape in plan view; and peripheral wall 72 that protrudes downward from the outer peripheral edge of top plate 71. Peripheral wall 72 illustrated in the figures includes folded portion 73 formed by folding back the top end portion of peripheral wall 72 inward by 180 degrees. Metal top cover 7 has a predetermined shape by press-forming a metal plate. Frame-shaped gasket 25C is fixed to top cover 7 along the inner surface of folded portion 73 which is the outer peripheral edge portion of the bottom surface of top plate 71.

Top cover 7 configured as above is configured to adjust the depth (D) of peripheral wall 72 to an optimal value by adjusting the folded amount of folded portion 73. Here, the depth (D) of peripheral wall 72 determines the elastic deformation amount (t-D) of gasket 25C disposed inside peripheral wall 72. Since top cover 7 is configured to be removed at the time of maintenance of power supply device 100, the aging degradation of gasket 25C is preferably inhibited. In general, when a gasket is compressed strongly to increase the elastic deformation amount, the gasket adheres tightly and enhances waterproofing; however, this leads to greater aging degradation. In contrast, when the gasket is compressed less to reduce the elastic deformation amount, the aging degradation is reduced, but the adhesion will be reduced, leading to a reduction in waterproofing. Therefore, in view of these factors, the elastic deformation amount of gasket 25C of top cover 7 at the time of connection is preferably set to an optimal value. As described above, the folded amount of folded portion 73 of peripheral wall 72 of top cover 7 can adjust the depth (D) of peripheral wall 72. In such a configuration, the elastic deformation amount of gasket 25C which is fixed to the bottom surface of top plate 71 is determined to an optimal value, allowing the maintenance of stable waterproofing while inhibiting the aging degradation.

### Positioning Member 75

Housing 2 illustrated in FIGS. 5 and 6 includes positioning members 75 that position frame-shaped gasket 25C fixed to top cover 7 connected to the top surface of housing 2, and determine the elastic deformation amount of gasket 25C. In housing 2 illustrated in the figures, positioning members 75 are fixed to the top surfaces of flange 55 of rear cover 5 and flange 65 of front cover 6 at the corners of the flanges facing the four corners of top cover 7.

Each positioning member 75 has an overall L-shape in plan view extending along the corner. Positioning member 75 illustrated in FIGS. 11 and 17 to 20 includes fixing portions 76, intermediate connection portion 77, and upstand portions 78. Fixing portions 76 are fixed to flange 55 or 65 at both ends of positioning member 75. Top cover 7 is connected to intermediate connection portion 77 at the intermediate portion of positioning member 75. Upstand portions 78 are provided between intermediate connection portion 77 and fixing portions 76 to position intermediate connection portion 77 at a predetermined height (H) with respect to fixing portion 76. Metal positioning member 75 can be processed to have a predetermined shape by performing, for example, a bending process on both ends of a metal plate bent into an L-shape in plan view.

Fixing portions 76 of positioning member 75 configured as above are fixed to flange 55 or 65 with screws 89, and intermediate connection portion 77 has threaded hole 85 into which connection screw 84 that passing through top cover 7 is inserted. Top cover 7 is fixed to positioning members 75 with connection screws 84 which are fixed via O-rings 87 as detachable connection members with a waterproof function. Top plate 71 has insertion holes 86. Intermediate connection portion 77 into which connection screw 84 is inserted has threaded hole 85 with nut member 88 fixed. Positioning member 75 with nut member 88 thus allows for reliable attachment and detachment of connection screw 84 over a long period of time. Threaded hole 85 may be provided by processes such as burring, instead of using the nut members.

As described above, positioning members 75 are fixed at the four corners of the top surface of main body 20 to which front cover 6 is connected. In other words, positioning members 75 are fixed to the corners of front cover 6 on the left and right sides of front cover 6 and the corners of rear cover 5 on the left and right sides of rear cover 5. This configuration allows frame-shaped gasket 25C which is fixed to the bottom surface of top cover 7 to be easily and reliably disposed at a fixed position while gasket 25C is in a fitted state. In particular, positioning members 75 illustrated in the figures positions the corners of gasket 25C at fixed positions along the outer peripheral edge of intermediate connection portions 77, and thus, the four corners of top cover 7 are disposed at the fixed positions reliably. Moreover, intermediate connection portions 77 are positioned apart from flanges 55 and 65. Hence, when top cover 7 is attached, positioning members 75 are not sandwiched between gasket 25C and flanges 55 and 65. This configuration does not inhibit elastic deformation of gasket 25C. Accordingly, frame-shaped gasket 25C appropriately elastically deforms, ensuring reliable waterproofing.

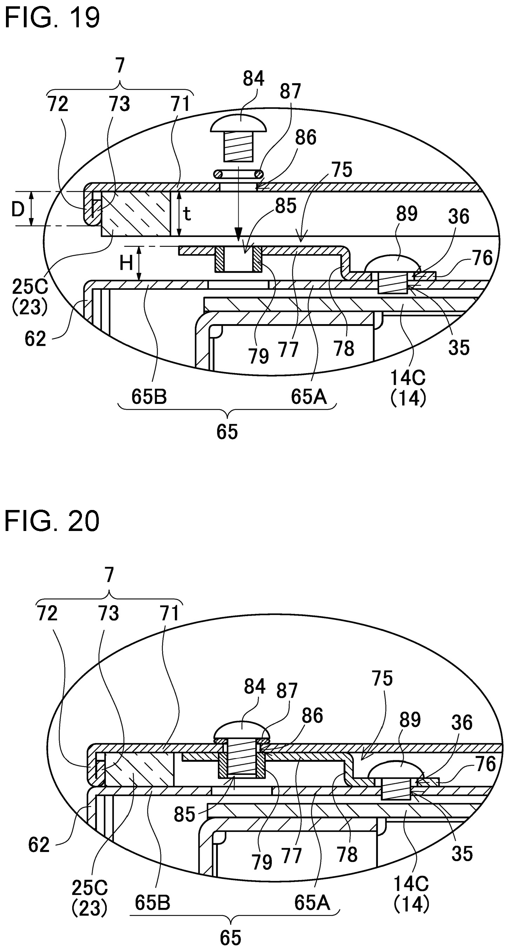

Positioning member 75 described above is configured to determine the elastic deformation amount (t-H) of gasket 25C by adjusting the height (H) of upstand portion 78 at the time of bending process. As illustrate in FIGS. 19 and 20, top cover 7 is fixed to positioning member 75 while the bottom surface of top plate 71 contacts the top surface of intermediate connection portion 77. Accordingly, by determining the height (H) of intermediate connection portion 77, the elastic deformation amount of gasket 25C is determined. In housing 2 configured as above, the elastic deformation amount of frame-shaped gasket 25C is determined by both peripheral wall 72 of top cover 7 and positioning member 75, that is, by both the outer and inner sides of gasket 25C. Therefore, the compression amount of gasket 25C is set to an appropriate value, ensuring reliable waterproofing while preventing the aging degradation.

### Gaskets 25A to 25E

As described above, gaskets 25A to 25E used for first to fourth waterproof members 21 to 24 may be rubber-like elastic body made of rubber or soft plastic. The gaskets may be made of, for example, silicone rubber.

### Electrical Unit 13

Electrical unit 13 includes electronic components configured to control the charge and discharge of secondary battery cells 1 included in battery assembly 11, as well as protective components to safeguard secondary battery cells 1 from, e.g., overcurrent. Electrical unit 13 illustrated in the figures includes circuit breaker 16 and fuse 15 connected between battery assembly 11 and an external output terminal (not illustrated).

### Circuit Breaker 16

Circuit breaker 16 enhances safety by interrupting the electrical path when overcurrent is detected in the total output of battery assembly 11. Circuit breaker 16 is a recoverable member that can be opened and closed. Circuit breaker 16 allows the user to manually restore the electrical path from the interrupted state to the connected state. Circuit breaker 16 illustrated in the figures includes a switch manually turned on and off.

### Fuse 15

Fuse 15 enhances safety by interrupting the electrical path when an overcurrent is detected. However, once fuse 15 detects an overcurrent, fuse 15 remains in an interrupted state, and does not reset even after the overcurrent subsides. Fuse 15 is a non-recoverable member that interrupts the conductive path by melting.

Power supply device 100 thus enhances safety with a double layer of protection using circuit breaker 16 and fuse 15. The operating current of circuit breaker 16 is lower than the operating current of fuse 15. This configuration provides a first protection with the operating current of circuit breaker 16 while providing a second protection with the operating current of fuse 15.

### Maintenance Method of Power Supply Device

A method for maintaining power supply device 100 described above will be described. Here, a method for replacing fuse 15 which is an example of a replacement component will be described.
(1) First, as indicated by arrow A in FIG. 5, top cover 7 provided at the top of housing 2 is removed. In this state, top opening 26 of main body 20 is opened.
(2) Next, as indicated by arrow B in FIG. 5, front cover 6 is removed from main body 20. In this state, inner cover 4 provided at the front of main body 20 is exposed.
(3) Then, as indicated by arrow C in FIG. 5, inner plate 8 connected to inner cover 4 is removed. In this state, opening window 44 provided in the upper end portion of front panel 41 opens. By thus removing inner plate 8 of inner cover 4, the front side of electrical unit 13 can be easily opened.
(4) Next, turn off circuit breaker 16 connected to the output side of battery assembly 11. Specifically, switch 16A of circuit breaker 16 illustrated in FIG. 2 is manually turned off.
(5) Fuse 15 is replaced while circuit breaker 16 is turned off. Specifically, the screws provided at both ends of fuse 15 are removed for replacement with new fuse 15, and new fuse 15 is fixed.
(6) Switch 16A of circuit breaker 16 is turned on.
(7) Inner plate 8 is attached to opening window 44 of front panel 41 of inner cover 4 to close opening window 44 of front panel 41.
(8) Front cover 6 is attached to the front surface of main body 20.
(9) Top cover 7 is connected to the top surface of main body 20 with front cover 6 attached.

By thus turning off circuit breaker 16 at the time of replacement of fuse 15, replacement work is safely performed while the voltage of battery assembly 11 is not generated in fuse 15.

### INDUSTRIAL APPLICABILITY

A power supply device according to the present disclosure is suitably used for, for example, stationary power supply devices, e.g., for households, offices, and factories, such as power storage devices that store electric power obtained from photovoltaic power generation or late night power, or power supplies for peak shaving during the day.

### REFERENCE MARKS IN THE DRAWINGS

100 power supply device
1 secondary battery cell
2 housing
3 bottom cover
4 inner cover
5 rear cover
6 front cover
7 top cover
8 inner plate
10 battery assembly
11 battery assembly
12 battery block
13 electrical unit
14 reinforcement frame
14A plate-shaped frame
14B bottom frame
14C top frame
14a protrusion
15 fuse
16 circuit breaker
16A switch
20 main body
21 first waterproof member
21x inner waterproof portion
21y rear waterproof portion
21z stepped portion
22 second waterproof member
22A vertical gasket
23 third waterproof member
24 fourth waterproof member
25,25A,25B,25C,25D,25E gasket
25a first gasket
25b second gasket
25c first gasket
25d second gasket
25m inner groove
26 top opening
31 bottom plate
32 peripheral wall
32A outer surface
32a upper region
32b lower region
33 raised portion
34 set screw
35 threaded hole
36 insertion hole
37 O-ring
39 fixing screw
41 front panel
42 bent portion
42A overlapping portion
42B folded portion
43 lower end portion
44 opening window
45 opening edge portion
46 positioning portion
46A horizontal portion
46B upstand portion
47 water-ingress prevention portion
51 rear panel
52 lateral panel
53 lower end portion
55 flange
55A rear flange
55B lateral flange
55C connection flange
55D cutout
56 slit
61 front-side panel
62 bent cover portion
65 flange
65A front flange
65B lateral flange
65C connection flange
65D cutout
66 slit
67 gap
71 top plate
72 peripheral wall
73 folded portion
75 positioning member
76 fixing portion
77 intermediate connection portion
78 upstand portion
79 nut member
81 main plate portion
82 inner plate portion
83 groove
84 connection screw
85 threaded hole
86 insertion hole
87 O-ring
88 nut member
89 set screw

## Claims

1. A power supply device comprising:
a battery assembly including a plurality of secondary battery cells; and
a housing accommodating the battery assembly therein, wherein
the housing includes:
a main body accommodating the battery assembly therein, the main body having a box shape having an opening in a top thereof;
a front cover detachably connected to a front surface of the main body to cover the front surface of the main body; and
a top cover detachably connected to a top surface of the main body to which the front cover has been connected,
the main body includes:
a bottom cover on which the battery assembly is placed, the bottom cover having a rectangular shape in plan view;
an inner cover including a front panel, a pair of bent portions, and an inner plate, the front panel being positioned at a front side of the main body, the pair of bent portions being connected to both side edges of the front panel to constitute parts of a pair of lateral surfaces of the main body; and
a rear cover including a rear panel, a pair of lateral panels, and a flange, the rear panel being positioned at a rear side of the main body, the pair of lateral panels being connected to both side edges of the rear panel to constitute the pair of lateral surfaces of the main body, the pair of lateral panels including front end portions that overlap the pair of bent portions of the inner cover and that are connected to the pair of bent portions of the inner cover, the flange being bent inward at upper edges of the rear panel and the pair of lateral panels,
each of the rear cover and the inner cover includes a lower end portion that is connected to the bottom cover via a first waterproof member with a waterproof structure, and portions of the pair of bent portions of the inner cover overlapping the pair of lateral panels are connected to the pair of lateral panels via a second waterproof member with a waterproof structure,
the inner plate of the inner cover has an opening window provided in a central portion of an upper end portion of the front panel, and the inner plate is detachably connected to the opening window to close the opening window with a waterproof structure,
the front cover includes:
a front-side panel covering the front panel of the inner cover;
a pair of bent cover portions connected to both side edges of the front-side panel to cover the pair of bent portions; and
a flange bent inward at upper edges of the front-side panel and the pair of bent cover portions,
while the front cover is connected to the main body, the flange of the front cover is flush with the flange of the rear cover, and
the top cover has a rectangular shape in plan view, and is connected to the flange of the front cover and the flange of the rear cover via a third waterproof member provided along an outer peripheral edge of the top cover with a waterproof structure.

2. The power supply device according to claim 1, wherein
each of the pair of bent portions of the inner cover includes an overlapping portion placed on a corresponding one of the pair of lateral panels of the rear cover, the overlapping portion being provided in a region of the each of the pair of bent portions excluding a lower end portion of the each of the pair of bent portions that faces the bottom cover, and
the second waterproof member is a gasket extending on the overlapping portion in an up-down direction.

3. The power supply device according to claim 2, wherein
the first waterproof member includes:
an inner waterproof portion provided between the inner cover and the bottom cover; and
a rear waterproof portion provided between the rear cover and the bottom cover,
the rear waterproof portion is thicker than the inner waterproof portion to provide a stepped portion,
each of the pair of lateral panels of the rear cover overlaps and is connected to the rear waterproof portion that protrudes from the inner cover connected to the bottom cover and the second waterproof member provided on the overlapping portion of the inner cover while the each of the pair of lateral panels faces the second waterproof member via the inner waterproof portion, and each of the pair of bent portions of the inner cover and a corresponding one of the pair of lateral panels of the rear cover are arranged in a stepped structure, and
while the front cover is connected to the main body, a rear edge of one of the pair of bent cover portions faces a front edge of one of the pair of lateral panels, the one of the pair of bent cover portions being flush with the one of the pair of lateral panels, and a rear edge of another of the pair of bent cover portions faces a front edge of another of the pair of lateral panels, the another of the pair of bent cover portions being flush with the another of the pair of lateral panels.

4. The power supply device according to claim 1, wherein
the bottom cover includes:
a bottom plate to which the battery assembly is fixed; and
a peripheral wall that extends along an outer peripheral edge of the bottom plate and that protrudes downward,
the first waterproof member is a gasket provided on an outer surface of the peripheral wall and having a loop shape extending along the outer surface of the peripheral wall, and
the gasket is provided along an upper region of the outer surface of the peripheral wall, and a lower end portion of the inner cover is fixed to a lower end portion of the rear cover in a lower region of the outer surface of the peripheral wall.

5. The power supply device according to claim 1, wherein
the inner cover includes positioning portions that position the flange of the rear cover and the flange of the front cover in a region across which the flange of the rear cover faces the flange of the front cover, the positioning portions protruding inward from upper edges of the pair of bent portions,
the positioning portions include:
a pair of horizontal portions that are bent inward from the upper edges of the pair of bent portions; and
a pair of upstand portions provided at top end portions of the pair of horizontal portions, the pair of upstand portions extending in a front-rear direction and protruding upward,
an end portion of the flange of the rear cover facing an end portion of the flange of the front cover has one slit therein, and the end portion of the flange of the front cover has another slit therein, the one slit and the another slit guiding the pair of upstand portions,
the one slit of the flange of the rear cover is guided toward rear ends of the pair of upstand portions to connect the rear cover to a fixed position on the inner cover, and
the another slit of the flange of the front cover is guided toward front ends of the pair of upstand portions to connect the front cover to a fixed position on the inner cover.

6. The power supply device according to claim 5, wherein a width of each of the pair of horizontal portions of the positioning portions in the front-rear direction is 10 mm or more, and a protrusion height of each of the pair of upstand portions of the positioning portions is 1 mm or more, such that each of the positioning portions serves as a water-ingress prevention portion configured to prevent water from entering through a gap in a region across which the rear cover faces the front cover.

7. The power supply device according to claim 1, wherein
the third waterproof member is a frame-shaped gasket that is fixed to an outer peripheral edge portion of a bottom surface of the top cover,
positioning members are fixed to corners of the flanges of the rear cover and the front cover positioned facing four corners of the top cover to position the frame-shaped gasket,
each of the positioning members has an L-shape in plan view along a corresponding one of the corners of the flanges of the rear cover and the front cover,
each of the positioning member includes:
fixing portions provided at both ends of the each of the positioning members and fixed to a corresponding one of the flanges;
an intermediate connection portion which is provided at an intermediate portion of the each of the positioning members, and to which the top cover is connected; and
upstand portions provided between the intermediate portion and each of the fixing portions, the upstand portions positioning the intermediate portion at a predetermined height with respect to the fixing portions, and
while the four corners of the top cover are connected to the positioning members, the frame-shaped gasket is disposed at a fixed position along outer peripheral edges of the intermediate connection portions, and an elastic deformation amount of the frame-shaped gasket is determined by the predetermined height of the intermediate connection portions.

8. The power supply device according to claim 1, wherein each of the pair of bent cover portions of the front cover is connected to the main body via a detachable connection member.

9. The power supply device according to claim 1, wherein
the battery assembly includes a reinforcement frame that positions the plurality of secondary battery cells at fixed positions, and
the flanges of the rear cover and the front cover are disposed on a top surface of the reinforcement frame.

10. The power supply device according to any one of claims 1 to 9, wherein the inner plate is fixed to the front panel while a fourth waterproof member is provided between an opening edge portion of the opening window of the front panel and the inner plate in an overlapping manner.

11. The power supply device according to any one of claims 1 to 9, wherein
the inner plate includes:
a main plate portion;
a fourth waterproof member that covers an outer peripheral edge portion of the main plate portion; and
inner plate portions that are provided on an inner side of the main plate portion to which the fourth waterproof member is attached to provide two grooves that guide an opening edge portion between the fourth waterproof member and each of the inner plate portions,
the fourth waterproof member attached to the main plate portion is a frame-shaped gasket,
at least on each of both sides of the main plate portion, one of the inner plate portions is disposed on an inner side of the frame-shaped gasket to provide a corresponding one of the two grooves, and
the inner plate portions are connected to the inner cover while the opening edge portion is guided along the two grooves.
